# EUROPÄISCHE PATENTSCHRIFT

(11) **EP 3 916 811 B1**
(45) Veröffentlichungstag und Bekanntmachung des Hinweises auf die Patenterteilung: **04.02.2026**
(21) Anmeldenummer: 21000132.7
(22) Anmeldetag: 17.12.2018
(51) Int. Cl.: H10D 8/00, H10D 8/01, H10D 8/60, H10D 12/01, H10D 12/00, H10D 62/10, H10D 62/53, H10D 62/60, H10D 62/85, H10D 62/854, H10D 62/824

(54) **STAPELFÖRMIGES III-V-HALBLEITERBAUELEMENT**
STACKED III-V SEMI-CONDUCTOR MODULE
COMPOSANT EMPILÉ À SEMI-CONDUCTEUR III-V

(30) Priorität: 21.12.2017 DE 102017011878
(43) Veröffentlichungstag der Anmeldung: 01.12.2021
(62) Teilanmeldung aus: 18000975.5
(73) Patentinhaber: 3-5 Power Electronics GmbH, 01217 Dresden (DE)
(72) Erfinder: Volker, Dudek, 76275 Ettlingen (DE)
(74) Vertreter: Koch Müller Patentanwaltsgesellschaft mbH

(56) Entgegenhaltungen:
- WO-A1-2016/204098
- US-A1- 2001 026 984
- US-A1- 2001 030 331
- US-A1- 2002 100 934
- US-A1- 2006 281 263
- US-A1- 2013 075 783
- US-A1- 2014 048 845
- US-A1- 2016 315 140
- US-A1- 2018 047 725
- TOM SIMON ET AL: "Gallium arsenide semiconductor parameters extracted from pin diode measurements and simulations", IET POWER ELECTRONICS, vol. 9, no. 4, 30 March 2016 (2016-03-30), UK, pages 689 - 697, XP055498441, ISSN: 1755-4535, DOI: 10.1049/iet-pel.2015.0019
- G ASHKINAW ET AL: "Solid-State Ekch~~ies PROCESS AND DEVICE CHARACTERIZATION OF HIGH VOLTAGE GALLIUM ARSENIDE P-i-N LAYERS GROWN BY AN IMPROVED LIQUID PHASE EPITAXY METHOD", 1 January 1993 (1993-01-01), pages 1749 - 1755, XP055498521, Retrieved from the Internet <URL:https://ac.els-cdn.com/003811019390222C/1-s2.0-003811019390222C-main.pdf?_tid=7233ad54-efe8-4ea2-88c8-5e338494f1ea&acdnat=1533743034_2745cb1569513a6a36b78720a87bc236>

## Beschreibung

Die Erfindung betrifft ein stapelförmiges III-V-Halbleiterbauelement.

Aus Josef Lutz et al, Semiconductor Power Devices, Springer Verlag, 2011, ISBN 978-3-642-11124-2, sind hochsperrende Schottky-Dioden sowie IGBTs auf Basis von Silizium oder SiC bekannt.

Aus "GaAs Power Devices" von German Ashkinazi, ISBN 965-7094-19-4, sind hochspannungsfeste Halbleiterdioden p⁺ - n - n⁺ sowie Schottky-Dioden, hochspannungsfeste p-n-i-p Transistoren auf GaAs Basis bekannt.

Weitere Halbleiterbauelemente sind aus der US 2006/0281263 A1; der US 2016/315140 A1; der US 2013/075783 A1; der WO 2016/204098 A1; der US 2018/047725 A1; aus Tom Simon et al: "Gallium arsenide semiconductor parameters extracted from pin diode measurements and simulations", IET POWER ELECTRONICS, Bd. 9, Nr. 4, 30. März 2016, Seiten 689-697; aus G. Ashkinazi et al: "PROCESS AND DEVICE CHARAKTERIZATION OF HIGH VOLTAGE GALLIUM ARSENIDE P-I-N LAYERS GROWN BY AN IMPROVED LIQUID PHASE EPITAXY METHOD", 1. Januar 1993 S.1749-1755; der US 2014/048845 A1; der US 2001/030331 A1; der US 2002/100934 A1 und der US 2001/026984 A1 bekannt.

Insbesondere offenbart die US 2006/0281263 A1 einen IGBT, der aus GaAs bestehen kann, mit einem p⁺ Substrat, einer n dotierten Zwischenschicht, einer n⁻ Driftschicht, einen p dotiertem Bereich, einen n⁺ dotierten Bereich und drei Anschlusskontaktschichten. Die Zwischenschicht umfasst Defekte, die die Lebensdauer der Minoritätsladungsträger beeinflussen.

Vor diesem Hintergrund besteht die Aufgabe der Erfindung darin, eine Vorrichtung anzugeben, die den Stand der Technik weiterbildet.

Die Aufgabe wird durch ein stapelförmiges III-V-Halbleiterbauelement mit den Merkmalen des Patentanspruchs 1 gelöst. Vorteilhafte Ausgestaltungen der Erfindung sind Gegenstand von Unteransprüchen.

Vorzugsweise ist die Konzentration der Defekte in der n-Schicht kleiner als 10¹⁷ N/cm³ höchst vorzugsweise kleiner als 5 x 10¹⁶ N/cm³.

Vorzugsweise lassen sich die meisten Schichten oder alle vorgenannten Halbleiterschichten mittels einer Flüssigphasenepitaxie (LPE) oder mittels einer MOVPE Anlage herstellen.

Im Unterschied zu der bisherigen Überzeugung, dass sich GaAs nur für schnelle Bauelemente oder Solarzellen mit Sperrspannungen im Niedervoltbereich, d.h. unterhalb 10 Volt eignen hat sich in überraschender Weise gezeigt, dass mittels der vorgenannten Epitaxieanlagen dicke n⁻-Schichten, d.h. Schichten oberhalb 30 µm oder vorzugsweise oberhalb 60 µm mit guter Kristallqualität einfach und kostengünstig abscheiden lassen.

Hierdurch wird es überraschender Weise möglich, hochsperrende Halbleiterbauelemente aus GaAs herzustellen. Mit hochsperrenden Bauelementen werden vorliegend Halbleiterbauelemente mit einer Sperrspannung oberhalb 100 V bezeichnet.

Bevorzugt bestehen die Anschlusskontakte aus metallisch leitfähigen Halbleiterschichten oder Metallschichten oder einer Kombination aus beiden. Die Anschlusskontakte stellen einen elektrisch niederohmigen Kontakt zu den unmittelbar angrenzenden dotierten Halbleiterschichten her.

Des Weiteren versteht es sich, dass die Anschlusskontakte vorzugsweise mittels Bonddrähte oder Lötverbindungen mit Kontaktfinger, den sogenannten Pins, verschaltet sind. Die Anschlusskontakte sind bevorzugt auf einer Oberseite bzw. einer Unterseite des aus den Halbleiterbereichen bzw. Halbleiterschichten gebildeten Stapels angeordnet.

In überraschender Weise zeigte sich, dass entgegen des bisherigen Bestrebens bei der Epitaxie Defekte wegen der Ausbildung von Rekombinationszentren auf jeden Fall zu vermeiden sind, um eine möglichst gute Kristallqualität zu erreichen, durch einen gezielten Einbau von Rekombinationszentren in der n⁻-Schicht Leckströme reduzieren lassen.

Durch den Einbau von Rekombinationszentren lässt sich die Diffusionslänge der Ladungsträger wesentlich verkleinern, so dass die Ladungsträger mit einer wesentlich geringeren Wahrscheinlichkeit in die Raumladungszone gelangen und nach ihrer Polarität getrennt werden.

Des Weiteren zeigte sich in überraschender Weise, dass im Vorwärtsbetrieb des Bauelements, d.h. die Raumladungszone wird mit Ladungsträger überschwemmt, der Stromfluss nur vernachlässigbar reduziert wird.

Anders ausgedrückt, eine Reduzierung des Leckstroms um den Faktor 10 bis 100, der bei hochsperrenden Bauelementen wie Dioden oder IGBT. Der Leckstrom liegt je nach Höhe der Sperrspannung und Temperatur in einem Bereich zwischen einigen pA und mA, ist im Vorwärtsbetrieb mit Strömen im Bereichen oberhalb einigen 100 mA bis einigen 10 A unerheblich.

Auch sei angemerkt, dass die Defektschicht vorzugsweise nicht innerhalb der Raumladungszone ausgebildet ist. Vorzugsweise ist die Dicke der n⁻-Schicht derart ausgebildet, dass die Defektschicht von der Raumladungszone beabstandet ist.

Ferner steigen die Leckströme mit der Temperatur stark an bis auf einige 10 mA. Aufgrund des exponentiellen Anstiegs mit steigender Temperatur sind daher gerade bei einem Einsatz in heißen Umgebungen von bis zu 300° niedrige Leckströme besonders hilfreich. Dies wird durch die erfindungsgemäße Defektschicht erreicht. Durch den Einbau der Defektschicht lassen sich die Leckströme um mehr als eine Größenordnung gegenüber Halbleiterbauelementen ohne Defektschicht reduzieren.

Des Weiteren wird der Herstellungsprozess wesentlich robuster, d.h. unempfindlich gegen eine hohe Hintergrunddotierung.

Ein weiterer Vorteil ist, dass sich mit der erfindungsgemäßen III-V-Halbleiterbauelementen auf einfache Weise insbesondere bei Dioden oder IGBTs niedrige Leckströme bei Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen.

Hierdurch sind Schaltfrequenzen von 30 kHz bis zu 0,5 GHz und Stromdichten von 0,5 A/mm² bis 5 A/mm² erreichbar. Dabei lässt sich die erfindungsgemäße III-V-Halbleiterdiode kostengünstiger herstellen als vergleichbare hochsperrende Dioden aus SiC.

Halbleiterdioden gemäß dieser nicht erfindungsgemäßen Ausführungsform lasser sich bevorzugt als Freilaufdioden verwenden.

Es sei angemerkt, dass die III-V-Halbleiterdioden gemäß dieser Ausführungsform kleine Einschaltwiderstände in einem Bereich zwischen 1 mOhm und 200 mOhm aufweisen. Die Kapazitäten pro Fläche liegen in einem Bereich zwischen 2 pF und 100 pF und ist deutlich geringer als vergleichbare SiC Dioden.

Ein anderer Vorteil ist, dass die Ladungsträger in GaAs Halbleiterstrukturen im Vergleich zu Silizium eine kleinere effektive Masse aufweisen. Auch lassen sich im Vergleich zu Si höheren Temperaturen an den pn-Übergängen erreichen, ohne dass die Bauelemente zerstört werden. Hierdurch lassen sich mit den GAs Halbleiterstrukturen mit hohen Sperrspannungen auch höhere Schaltfrequenzen und geringere Verluste als mit den vergleichbaren Si Hableiterstrukturen erzielen. Außerdem lassen sich die erfindungsgemäßen III-V-Halbleiterbauelemente dank einer hohen Temperaturfestigkeit von bis zu 300°C auch in heißen Umgebungen, d. h in einem Bereich bis 180°C einsetzten.

Ein weiterer Vorteil ist, dass sich die III-V-Halbleiterdioden wesentlich kostengünstiger als vergleichbare hochsperrende Dioden aus SiC herstellen lassen.

In einer Ausführungsform wird die Oberfläche des p⁺-Substrats metallisiert, um die Bauelemente, insbesondere die Halbleiter-Diode elektrisch anzuschließen.

Nicht erfindungsgemäß wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p+-Schicht ausgebildet.

Gemäß einer nicht beanspruchten alternativen Ausführungsformsind der p⁺-Bereich und der n⁺-Bereich schichtförmig ausgebildet und der schichtförmige n⁺-Bereich und der schichtförmige p⁺-Bereich jeweils stoffschlüssig mit der n⁻-Schicht verbunden, wobei der schichtförmige n⁺-Bereich eine Schichtdicke von 50 - 675 µm aufweist und der schichtförmige p⁺-Bereich eine Schichtdicke größer 2 µm aufweist.

In einer nicht beanspruchten Weiterbildung umfasst der n⁻-Bereich eine Defektschicht mit einer Schichtdicke zwischen 0,5 µm und 50 µm, wobei die Defektschicht eine Defektkonzentration in einem Bereich zwischen 1•10¹³ N/cm³ und 5•10¹⁶ N/cm³ aufweist.

Bevorzugt weist die Defektschicht zu einer Grenzfläche einen Abstand auf.

Der Ausdruck Grenzfläche bezeichnet vorliegend den Übergang zwischen zwei unterschiedliche dotierten Schichten oder Bereichen, insbesondere der Übergang zwischen der n⁻-Schicht und der Zwischenschicht oder der Übergang zwischen der n⁻-Schicht dem p⁺-Bereich oder der Übergang zwischen der n⁻-Schicht und dem n⁺-Bereich. Vorzugsweise beträgt der Abstand höchstens die Hälfte der Schichtdicke der n⁻-Schicht.

Es versteht sich, dass sich die Defektschicht auf unterschiedliche Weise, beispielsweise durch Implantation oder mittels Einbau von Fremdatomen erzeugen lässt und innerhalb der Defektschicht eine Rekombination von Ladungsträger erreicht wird. Vorzugsweise werden die Defekte bzw. die Rekombinationszentren durch Einbau von Chrom erreicht.

Gemäß einer anderen alternativen Ausführungsform sind der p⁺-Bereich und der n⁺-Bereich schichtförmig ausgebildet sind, wobei der schichtförmige n⁺-Bereich stoffschlüssig mit der n⁻-Schicht verbunden ist und zwischen der n⁻-Schicht und der p⁺-Schicht eine dotierte Zwischenschicht mit einer Schichtdicke von 1-50 µm und einer Dotierstoffkonzentration von 10¹²-10¹⁷ cm³ angeordnet ist und die Zwischenschicht mit der n⁻-Schicht und mit der p⁺-Schicht stoffschlüssig verbunden ist.

Es versteht sich, dass die Zwischenschicht eine im Vergleich zu den stoffschlüssig verbundenen Schichten wenigstens eine unterschiedliche Dotierstoffkonzentration aufweist.

Bevorzugt ist die Zwischenschicht p-dotiert und umfasst besonders bevorzugt Zink oder Silizium. Die Dotierstoffkonzentration der p-dotierten Zwischenschicht ist besonders bevorzugt kleiner als die Dotierstoffkonzentration des p⁺-Bereichs, insbesondere um einen Faktor 2 bis zu einem Faktor von 5 Größenordnungen.

Alternativ ist die Zwischenschicht n-dotiert und umfasst bevorzugt Silizium und/oder Zinn, wobei die Dotierstoffkonzentration der n-dotierten Zwischenschicht besonders bevorzugt um bis zu einem Faktor 100 kleiner als die Dotierstoffkonzentration des n⁻-Bereichs ist.

Ein Vorteil ist, dass sich mit der gemäß dieser nicht beanspruchten Ausführungsform ausgebildeten III-V-Halbleiterdiode auf einfache Weise Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen lassen. Hierdurch sind Schaltfrequenzen von 30 kHz bis zu 0,5 GHz und Stromdichten von 0,5 A/mm² bis 5 A/mm² erreichbar. Insbesondere lassen sich die erfindungsgemäßen III-V-Halbleiterdioden als Freilaufdioden verwenden.

Es sei angemerkt, dass auch die III-V-Halbleiterdioden gemäß dieser Ausführungsform kleine Einschaltwiderstände in einem Bereich zwischen 1 mOhm und 200 mOhm aufweisen. Die Kapazitäten pro Fläche liegen in einem Bereich zwischen 2 pF und 100 pF.

Auch sei angemerkt, dass die Defektschicht möglichst nicht innerhalb der Raumladungszone ausgebildet ist. Vorzugsweise ist die Dicke der p-Schicht derart ausgebildet, so dass die Defektschicht von der Raumladungszone beabstandet ist.

Erfindungsgemäß sind der p⁺-Bereich und der n⁺-Bereich schichtförmig ausgebildet, der schichtförmige n⁺-Bereich und der schichtförmige p⁺-Bereich stoffschlüssig mit der n⁻-Schicht verbunden und die Dotierstoffkonzentration steigt innerhalb der n⁻-Schicht von der an den p⁺-Bereich angrenzenden Oberfläche der n⁻-Schicht zu der an den n⁺-Bereich angrenzenden Oberfläche der n⁻-Schicht um einen Faktor zwischen 1,5 und 2,5 an.

Bevorzugt ändert sich die Dotierstoffkonzentration der n--Schicht 14 stufenförmig, d.h. die Dotierstoffkonzentration weist ein parallel zu der Schichtdicke der n--Schicht 14 verlaufendes Profil mit mindestens einer Stufe oder auch mehreren Stufen auf. Alternativ weist das Profil einen Gradienten also einen stetigen Anstieg auf.

Gemäß einer ersten alternativen Weiterbildungen ist der schichtförmige p⁺-Bereich als Substrat mit einer Schichtdicke von 50-500 µm ausgebildet und der schichtförmige n⁺-Bereich weist eine Schichtdicke kleiner 30 µm auf.

Nach einer zweiten alternativen Weiterbildung ist der schichtförmige n⁺-Bereich als Substrat mit einer Schichtdicke von 50-400 µm ausgebildet und der schichtförmige p⁺-Bereich weist eine Schichtdicke größer 2 µm auf.

Gemäß einer weiteren Weiterbildung sind der p⁺-Bereich und der n⁺-Bereich schichtförmig ausgebildet sind, zwischen der n⁻-Schicht und dem p⁺-Bereich eine p-dotierte Zwischenschicht mit einer Schichtdicke von 1-50 µm und einer Dotierstoffkonzentration von 10¹²-10¹⁷ N/cm³ angeordnet ist, der schichtförmige n⁺-Bereich und die Zwischenschicht jeweils stoffschlüssig mit der n⁻-Schicht und der schichtförmige p⁺-Bereich mit der Zwischenschicht stoffschlüssig verbunden ist und das stapelförmige III-V-Halbleiterbauelement eine erste Defektschicht mit einer Schichtdicke zwischen 0,5 µm und 40 µm aufweist, wobei die Defektschicht innerhalb der p-dotierten Zwischenschicht angeordnet ist und eine Defektkonzentration in einem Bereich zwischen 1•10¹³ N/cm³ und 5•10¹⁶ N/cm³ aufweist.

Für die Zwischenschicht und die Defektschicht dieser Ausführungsform gelten die im vorangegangenen gemachten Ausführungen.

In einer weiteren Ausführungsform weist der stapelförmige Schichtaufbau bestehend aus dem p⁺-Substrat, der n--Schicht und der n⁺-Schicht ein zwischen der n⁻-Schicht und dem p⁺-Substrat ausgebildeter Halbleiterbond auf.

Es wird angemerkt, dass der Ausdruck Halbleiterbond synonym mit dem Ausdruck Waferbond verwendet wird.

In einer Ausführungsform bildet der Schichtaufbau bestehend aus einem p⁺-Substrat bildet einen ersten Teilstapel und der Schichtaufbau bestehend aus der n⁺-Schicht eine der n⁻-Schicht bildet einen zweiten Teilstapel.

In einer Weiterbildung umfasst der stapelförmige Schichtaufbau eine zwischen dem p⁺-Substrat und der n⁻-Schicht angeordnete Zwischenschicht auf. Hierbei umfasst der erste Teilstapel die Zwischenschicht. Der Halbleiterbond ist zwischen der Zwischenschicht und der n⁻-Schicht angeordnet.

In einer Weiterbildung sind der erste Teilstapel und der zweite Teilstapel jeweils monolithisch ausgebildet.

In einer anderen Weiterbildung wird der erste Teilstapel gebildet, in dem ausgehend von einem p⁺-Substrat mittels Epitaxie die Zwischenschicht hergestellt wird. Vorzugsweise weist die als p⁻-Schicht ausgebildete Zwischenschicht eine Dotierung kleiner als 10¹³ N/cm⁻³, d.h. die Zwischenschicht ist intrinsisch dotiert, oder eine Dotierung zwischen 10¹³ N/cm⁻³ und 10¹³ N/cm⁻³ auf. In einer Ausführungsform wird das p⁺-Substrat vor oder nach dem Bonden durch einen Schleifprozess auf eine Dicke zwischen 200 µm und 500 µm gedünnt.

In einer anderen Ausführungsform wird der zweite Stapel gebildet, in dem ausgehend von einem n⁻-Substrat, das n⁻-Substrat mit dem zweiten Stapel, d.h. mit der n⁺-Schicht durch einen Waferbondprozess verbunden wird. In einer Ausführungsform ist die n⁺-Schicht als n⁺-Substrat ausgebildet.

In einem weiteren Prozessschritt wird das n⁻-Substrat auf die gewünschte Dicke gedünnt.

Vorzugsweise liegt die Dicke des n⁻-Substrats in einem Bereich zwischen 50 µm bis 250 µm. Vorzugsweise liegt die Dotierung des n⁻-Substrats in einem Bereich zwischen 10¹³ N/cm⁻³ und 10¹⁵ N/cm⁻³. Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Waferbondens die Anzahl der Stapelfehler verringern.

In eine alternativen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer Weiterbildung wird das n⁻-Substrat unmittelbar auf den ersten Stapel mittels eines Halbleiterbondprozessschrittes verbunden. Anschließend wird das n⁻-Substrat auf die gewünschte Dicke der n⁻-Schicht gedünnt. Nach dem Dünnen des n⁻-Substrats bzw. der n⁻-Schicht wird mittels Epitaxie oder einer Hochdosisimplantation die n⁺-Schicht mit einer Dotierung in einem Bereich zwischen 10¹⁸ N/cm⁻³ und kleiner als 5×10¹⁹ N/cm⁻³ erzeugt.

Es versteht sich, dass das Dünnen des n⁻-Substrats vorzugsweise mittels eines CMP Schrittes, d.h. mittels chemischen mechanischen Polierens erfolgt.

In einer anderen Weiterbildung weist das stapelförmige Halbleiterbauelement eine erste Anschlusskontaktschicht, eine zweite Anschlusskontaktschicht und eine p⁻-Schicht auf, wobei die p⁻-Schicht eine Dotierstoffkonzentration zwischen 10¹² und 10¹⁶ N / cm³ und eine Schichtdicke zwischen 10 nm und 10um aufweist und eine GaAs-Verbindung umfasst oder aus einer GaAs-Verbindung besteht oder weitere III-V Verbindungen umfasst oder aus weiteren III-V Verbindungen besteht.

Der n⁺-Bereich ist schichtförmig mit einer Schichtdicke zwischen 50µm und 400 µm ausgebildet und die Unterseite der n⁻-Schicht ist stoffschlüssig mit der Oberseite des schichtförmigen n⁺-Bereichs verbunden.

Die p⁻-Schicht ist stoffschlüssig mit der Oberseite der n⁻-Schicht verbunden, der p⁺-Bereich aus mindestens zwei zueinander beabstandeten Teilbereichen besteht, wobei jeder Teilbereich des p⁺-Bereichs eine Dotierstoffkonzentration von 5 • 10¹⁸-5 • 10²⁰ N / cm³ aufweist, als parallel zu einer Oberseite der p⁻-Schicht nicht erfindungsgemäße verlaufende Rippe ausgebildet ist und von der Oberseite der p⁻-Schicht bis in die n⁻-Schicht hineinreicht.

Vorzugsweise sind die nicht erfindungsgemäßen Rippen entlang bestimmten kristallographischen Richtungen ausgebildet, d.h. die Rippen verlaufen bevorzugt entlang von einer gegebenen kristallographischen Richtung.

Die erste Anschlusskontaktschicht ist stoffschlüssig mit der Unterseite des n⁺-Bereichs verbunden.

Die zweite Anschlusskontaktschicht ist mit einem Teil der Oberseite der p⁻-Schicht stoffschlüssig und elektrisch leitfähig verbunden, wobei die zweite Anschlusskontaktschicht mit der gesamten Oberseite oder einem Teil der Oberseite jedes Teilbereichs des p⁺-Bereichs stoffschlüssig und elektrisch leitfähig verbunden ist.

Die zweite Anschlusskontaktschicht umfasst ein Metall oder eine metallische Verbindung oder besteht aus einem Metall oder einer metallischen Verbindung und bildet einen Schottky-Kontakt aus.

Es sei angemerkt, dass die zweite Anschlusskontaktschicht als Anode und die erste Anschlusskontaktschicht als Kathode bezeichnet wird. Hierbei bildet die erste Anschlusskontaktschicht einen ohmschen Kontakt die zweite Anschlusskontaktschicht einen Metall- Halbleiterübergang aus. Es versteht sich, dass auf den Anschlusskontaktschichten noch weitere Schichten ausbilden lassen, um beispielsweise die Schottky-Diode zu bonden.

Ein Vorteil ist, dass sich der nicht erfindungsgemäße Schottky-Kontakt mittels der sehr dünnen niedrig dotierten p-Schicht als dritte Halbleiterschicht und den p⁺-Bereiche, welche an den Kanten und vorzugsweise unterhalb der zweiten Kontaktanschlussschicht ausgebildet sind, vollständig von dem Durchgriff des hohen elektrischen Feldes abschirmen lässt. Hierzu sind die Rippen relativ nahe zusammen, sodass nur relativ schmale n⁻-Schichtbereiche zwischen benachbarten Rippen verbleiben.

Hierdurch lassen sich Sperrspannungen der nicht erfindungsgemäßen Schottky-Diode in einem Bereich zwischen 200 V und 600 V und auch oberhalb von 600 V ohne weiteres erreichen. In Verbindung mit der von GaAs im Vergleich zu Silizium wesentlich kleineren effektiven Masse lassen sich schnelle Schaltzeiten erzielen. Die erfindungsgemäße Schottky-Diode eignet sich damit insbesondere als Freilaufdiode im Bereich der Leistungselektronik vorzugsweise bei Schaltnetzteilen und Umrichtern.

Bevorzugt ist die zweite Anschlusskontaktschicht viereckig, viereckig mit abgerundeten Eckkanten, oder kreisförmig ausgebildet und überdeckt vorzugsweise mehr als 30 %, höchst vorzugsweise mehr als 50 % der Fläche der Halbleiterschicht an der Oberseite des Halbleiterstapels.

Bevorzugt ist auf der p⁻-Schicht eine weitere als eine n⁻-Schicht ausgebildete Halbleiterschicht angeordnet, wobei die weitere n⁻-Schicht eine Dotierstoffkonzentration zwischen von 10¹² N/cm³ und 10¹⁶ N/cm³ und eine Schichtdicke zwischen 0,005 µm und 10 µm aufweist und eine GaAs-Verbindung umfasst oder aus einer GaAs Verbindung besteht. Die weitere n⁻-Schicht bildet dann eine Oberseite des Stapels aus, wobei die sich die p⁺-Bereiche von einer Oberseite der weiteren n⁻-Schicht durch die weitere n⁻-Schicht und die p⁺-Schicht bis in die darunter liegende n⁻-Schicht erstrecken.

Erfindungsgemäß weist das III-V-Halbleiterbauelement mindestens einen p-Bereich, eine vorzugsweise aus einem oder mehreren abgeschiedenen Schichten (Oxid, Ntrid) bestehende dielektrische Schicht und mindestens drei Anschlusskontaktschichten auf, wobei der p⁺-Bereich als schichtförmiges Substrat mit einer Schichtdicke von vorzugsweise 50 - 500 µm ausgebildet ist, der p-Bereich an die n⁻-Schicht angrenzt, eine Dotierstoffkonzentration von 10¹⁴-10¹⁸ cm³ aufweist und eine GaAs-Verbindung umfasst oder aus einer GaAs Verbindung besteht, der mindestens eine p-Bereich mit der n⁻-Schicht einen ersten pn-Übergang ausbildet und der n⁺-Bereich mit dem mindestens einen p-Bereich einen zweiten pn-Übergang ausbildet. Die dielektrische Schicht überdeckt zumindest den ersten pn-Übergang und den zweiten pn-Übergang und ist mit der n⁻-Schicht, dem p-Bereich und dem n⁺-Bereich stoffschlüssig verbunden. Zwischen dem schichtförmigen p⁺-Bereich und der n⁻Schicht ist eine dotierte Zwischenschicht mit einer Schichtdicke von 1 µm -50 µm und einer Dotierstoffkonzentration von 10¹²-10¹⁷ cm³ angeordnet, wobei die Zwischenschicht zumindest mit dem schichtförmigen p⁺-Bereich stoffschlüssig verbunden ist. Die erste Anschlusskontaktschicht ist elektrisch leitfähig mit der Unterseite des schichtförmigen p⁺-Bereichs verbunden, die zweite Anschlusskontaktschicht ist als Feldplatte auf der dielektrischen Schicht ausgebildet und die dritte Anschlusskontaktschicht ist mit dem mindestens einen p-Bereich und dem mindestens einen n⁺-Bereich elektrisch leitfähig verbunden. Es sei angemerkt, dass die zweite Anschlusskontaktschicht als Gate bezeichnet wird. Die erste Anschlusskontaktschicht wird typischerweise als Kollektor oder Anode bezeichnet, während die dritte Anschlusskontaktschicht als Emitter oder Kathode bezeichnet wird.

Es versteht sich, dass die Zwischenschicht der IGBT-Halbleiterstruktur eine im Vergleich zu den angrenzenden Schichten wenigstens eine unterschiedliche Dotierstoffkonzentration aufweist. Das im Vorangegangenen hinsichtlich der Zwischensicht in einer Halbleiterdiode Ausgeführte, insbesondere wie die Ausführungsformen oder die Vorteile, gelten auch auf die Zwischenschicht in einer IGBT-Halbleiterstruktur entsprechend.

Bevorzugt beträgt eine Gesamthöhe der IGBT Halbleiterstruktur höchstens 150-500 µm und /oder eine Kantenlänge oder ein Durchmesser der IGBT Halbleitstruktur betragen zwischen 1 mm und 15 mm. Besonders bevorzugt sind der p-Bereich und/oder der n-Bereich an der Oberseite der IGBT Halbleiterstruktur kreisförmig oder gerade, mit jeweils an der Stirnseite der Strukturen angeordneten Halbkreisen ausgebildet.

Gemäß einer Weiterbildung umfasst die dielektrische Schicht ein abgeschiedenes Oxid und weist eine Schichtdicke von 10nm bis 1µm auf.

Ein Vorteil ist, dass sich die III-IV IGBT Halbleiterstruktur kostengünstiger als vergleichbare Halbleiterstrukturen aus SiC herstellen lassen. Wegen der höheren Minoritätsladungsträger Lebensdauer besitzt der GaAs IGBT im Vergleich zu vergleichbaren SIC Bauelementen eine höhere Stromtragfähigkeit.

Ein anderer Vorteil der erfindungsgemäßen III-V-IGBT-Halbleiterstruktur ist eine hohe Temperaturfestigkeit von bis zu 300°C. Anders ausgedrückt lassen sich die III-V-Halbleiterdioden auch in heißen Umgebungen einsetzten.

Gemäß einer anderen Ausführungsform umfasst der p⁺-Bereich Zink und/oder der n⁺-Bereich Chrom und/oder Silizium und/oder Palladium und/oder Zinn und/oder die n⁻-Schicht Silizium und/oder Palladium und/oder Zinn.

Untersuchungen haben gezeigt, dass sich mit bestimmten Kombinationen von einer p⁻- Zwischenschicht und n⁻-Schicht verschiedene Sperrspannungen insbesondere für Halbleiterdioden erzielen lassen.

In einer ersten Variante umfasst die:
für eine Sperrspannung von ca. 900 V die p⁻- Zwischenschicht eine Dicke zwischen 10 µm bis 25 µm und für die n⁻-Schicht eine Dicke zwischen 40 µm und 90 µm.

In einer zweiten Variante umfasst die:
für eine Sperrspannung von ca. 1200 V die p⁻- Zwischenschicht eine Dicke zwischen 25 µm bis 35 µm und für die n⁻-Schicht eine Dicke zwischen 40 µm und 70 µm.

In einer dritten Variante umfasst die:
für eine Sperrspannung von ca. 1500 V die p⁻- Zwischenschicht eine Dicke zwischen 35 µm bis 50 µm und für die n⁻-Schicht eine Dicke zwischen 70µm und 150 µm und 70 µm.

Die Dioden in der ersten bis dritten Variante lassen sich auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 25 µm bis 35 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich auch als n "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine Ansicht auf eine nicht erfindungsgemäße Ausführungsform eines stapelförmigen III-V-Halbleiterbauelements,
- Figur 2: eine Aufsicht auf das stapelförmige III-V-Halbleiterelement der nicht erfindungsgemäße Ausführungsform der Figur 1,
- Figur 3: eine Ansicht einer nicht erfindungsgemäßen Ausführungsform einer stapelförmigen III-V-Halbleiterdiode,
- Figur 4: eine Ansicht einer nicht erfindungsgemäßen Ausführungsform einer stapelförmigen III-V-Halbleiterdiode,
- Figur 5: eine Ansicht einer nicht erfindungsgemäßen Ausführungsform einer stapelförmigen III-V-Halbleiterdiode,
- Figur 6: eine Ansicht einer nicht erfindungsgemäßen Ausführungsform einer stapelförmigen III-V-Halbleiterdiode,
- Figure 7: eine Ansicht einer nicht erfindungsgemäßen Ausführungsform einer Schottky-Diode,
- Figur 8: eine Ansicht einer nicht erfindungsgemäßen alternativen Ausführungsform einer Schottky-Diode,
- Figur 9: eine Ansicht einer erfindungsgemäßen Ausführungsform einer IGBT Halbleiterstruktur,
- Figur 10: eine Aufsicht auf die IGBT Halbleiterstruktur der Figur 9,
- Figur 11: eine Ansicht einer weiteren erfindungsgemäßen Ausführungsform einer IGBT Halbleiterstruktur.

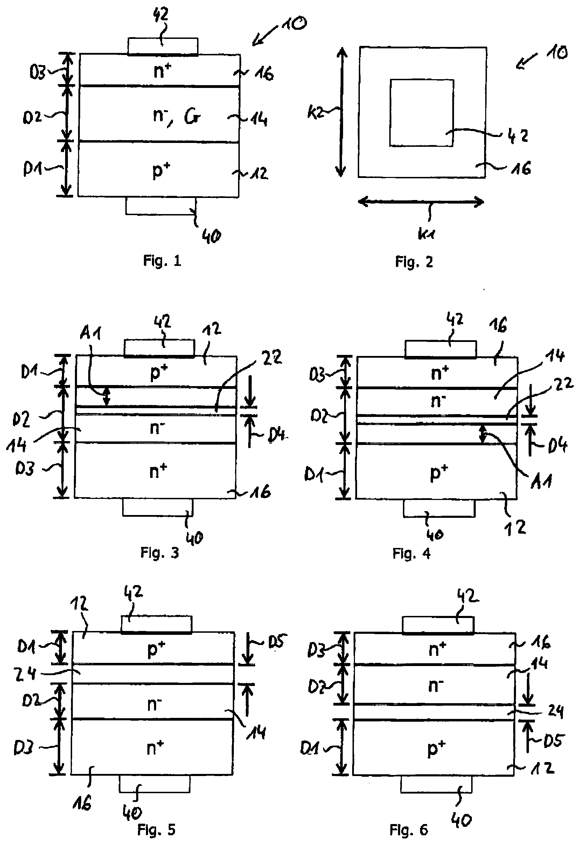

Die Abbildung der Figur 1 zeigt eine seitliche Ansicht einer nicht erfindungsgemäßen Ausführungsform eines stapelförmigen III-V-Halbleiterbauelements 10. Die Abbildung der Figur 2 eine Aufsicht auf das III-V-Halbleiterbauelement 10. Das Bauelement 10 ist als Diode mit einem Stapel aus drei Halbleiterschichten und zwei Kontaktschichten ausgebildet, wobei jede der Halbleiterschichten eine GaAs-Verbindung umfasst oder aus einer GaAs-Verbindung besteht.

Die erste Halbleiterschicht ist ein als Substrat ausgebildeter p⁺-Bereich 12 mit einer Schichtdicke D1 und ist stark p-dotiert mit einer Dotierstoffkonzentration von 5•10¹⁸-5•10²⁰ N/cm³. Die zweite Halbleiterschicht ist eine erste n⁻-Schicht 14 mit einer Schichtdicke D2. Die dritte Halbleiterschicht ist ein stark n-dotierter, schichtförmig ausgebildeter n⁺-Bereich 16 mit einer Dotierstoffkonzentration von mindestens 10¹⁹ N/cm³. Die drei Halbleiterschichten sind in der genannten Reihenfolge monolithisch aufeinander gewachsen, so dass eine Unterseite der n⁻-Schicht 14 stoffschlüssig mit einer Oberseite des p⁺-Substrats und eine Unterseite der n⁺-Schicht stoffschlüssig mit der n⁻-Schicht 14 verbunden sind.

Die n⁻-Schicht 14 ist schwach n-dotiert mit einer Dotierstoffkonzentration zwischen 10¹² N/cm³ und 10¹⁷ N/cm³, wobei die Dotierstoffkonzentration in eine Richtung von der Unterseite der n⁻-Schicht 14 zu der Oberseite der n⁻-Schicht 14 um einen Faktor von 1,5 bis 2,5 zunimmt. Außerdem umfasst die n⁻-Schicht 14 Chrom Cr mit einer Konzentration von mindestens 10¹⁴ N/cm³ oder mindestens 10¹⁵ N/cm³.

Eine erste Kontaktschicht 40 ist stoffschlüssig und elektrisch leitfähig mit der Unterseite des p⁺-Substrats 12, also der Unterseite des Stapels, und eine zweite Kontaktschicht 42 stoffschlüssig und elektrisch leitfähig mit der Oberseite der n⁺-Schicht, also der Oberseite des Stapels, verbunden, wobei die beiden Kontaktschichten 40 und 42 gemäß dem dargestellten Ausführungsbeispiel die jeweilige Oberfläche der Halbleiterschicht nur teilweise überdecken.

Alternativ ist die n⁺-Schicht als Substrat ausgebildet, auf dem die 14 und ein schichtförmiger p⁺-Bereich epitaktisch erzeugt sind, so dass die Unterseite der n⁺-Schicht die Unterseite des Stapels bildet und die Oberseite des Stapels die Oberseite der p⁺-Schicht ist (nicht dargestellt).

In der Abbildung der Figur 3 ist eine weitere Ausführungsform eines nicht erfindungsgemäßen III-V-Halbleiterbauelements als Diode dargestellt. Im Folgenden werden nur die Unterschiede zu der Abbildung der Figur 1 erläutert.

Der n⁺-Bereich 14 ist als Substrat ausgebildet, auf dem die n⁻-Schicht 14 und ein schichtförmiger p⁺-Bereich aufgewachsen sind.

Die n⁻-Schicht 14 ist niedrig n-dotiert und weist eine über die gesamte Schicht konstante Dotierstoffkonzentration auf. Innerhalb der n⁻-Schicht 14 ist eine Defektschicht 22 mit einer Defektkonzentration in einem Bereich zwischen 1•10¹³ N/cm³ und 5•10¹⁶ N/cm³ und einer Schichtdicke D4 0,5 µm und 50 µm angeordnet, wobei die Defektschicht 22 einen erster Abstand A1 zu einer Grenzfläche zwischen der n⁻-Schicht 14 und dem p⁺-Bereich 12, also zu der Oberseite der n⁻-Schicht 14, aufweist.

In der Abbildung der Figur 4 ist eine zu der Darstellung der Figur 3 alternativen nicht erfindungsgemäßen Ausführungsform gezeigt, wobei die Reihenfolge der Halbleiterschichten invertiert ist, so dass der p⁺-Bereich 12 als schichtförmiges Substrat ausgebildet ist, gefolgt von der die Defektschicht 22 enthaltenden n⁻-Schicht 14 und der n⁺-Schicht 16. Der erste Abstand A1 gibt entsprechend den Abstand der Defektschicht 22 zu der Unterseite der n⁻-Schicht 14 an.

In der Abbildung der Figur 5 ist eine weitere alternative Ausführungsform eines nicht erfindungsgemäßen III-V-Halbleiterbauelements als Diode dargestellt. Im Folgenden werden nur die Unterschiede zu der Abbildung der Figur 1 erläutert.

Das III-V-Halbleiterbauelement 10 weist den n⁺-Bereich 12 als Substrat auf, gefolgt von der n⁻-Schicht 14 mit einer über die gesamte Schicht konstanten Dotierstoffkonzentration, einer Zwischenschicht 24 mit einer Schichtdicke D5 und der p⁺-Schicht 12. Die Zwischenschicht 24 ist p- oder n- dotiert mit einer Dotierstoffkonzentration von 10¹² - 10¹⁷ cm³.

In der Abbildung der Figur 6 ist eine zu der Darstellung der Figur 5 alternative nicht erfindungsgemäßen Ausführungsform gezeigt, wobei die Reihenfolge der Halbleiterschichten invertiert ist, so dass der p⁺-Bereich 12 als Substrat ausgebildet ist und von der Zwischenschicht 24, der n⁻-Schicht 14 und der n⁺-Schicht in der genannten Reihenfolge gefolgt wird.

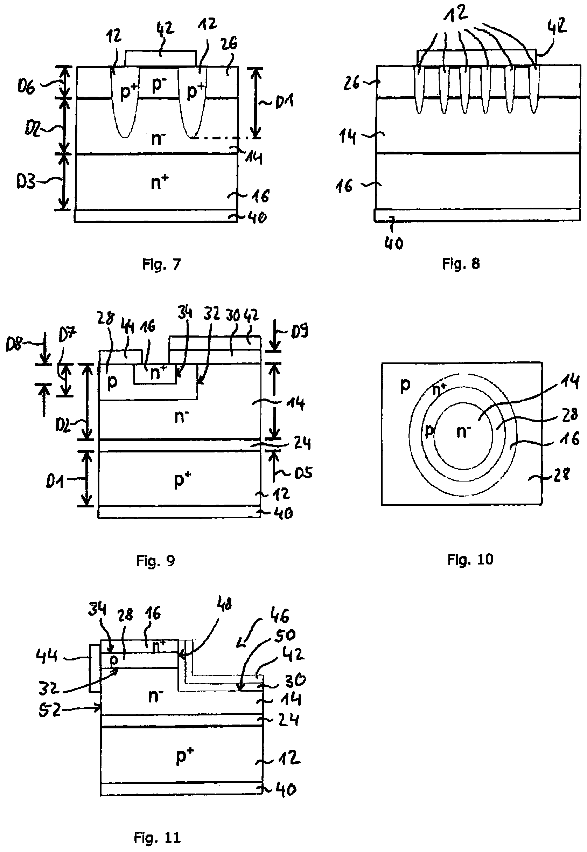

In der Abbildung der Figur 7 ist eine weitere alternative Ausführungsform eines nicht erfindungsgemäßen III-V-Halbleiterbauelements 10 dargestellt. Im Folgenden werden nur die Unterschiede zu den vorangegangenen Abbildungen erläutert.

Das III-V-Halbleiterbauelement 10 ist als Schottky-Diode ausgebildet, aufweisend den als Substrat ausgebildeten n⁺-Bereich gefolgt von dem monolithisch auf dem Substrat gewachsenen schichtförmigen n⁻-Bereich 14 und einer auf dem n⁻-Bereich 14 aufgewachsenen p⁻-Schicht 26 mit einer Schichtdicke D6. Der p⁺-Bereich 12 weist zwei zueinander beabstandete Teilbereiche auf, wobei sich die Teilbereiche von einer Oberseite der p⁻-Schicht 26 bis zu einer Tiefe D1 durch die gesamte p⁻-Schicht 26 bis in die n⁻-Schicht 14 hinein erstrecken.

Die erste Anschlusskontaktschicht 40 überdeckt in dem dargestellten Ausführungsbeispiel die gesamte Unterseite des n⁺-Substrats, während die zweite Anschlusskontaktschicht 42 nur einen Teil der Oberseite der p⁻-Schicht 26 sowie jeweils einen Teil einer Oberseite jedes p⁺-Teilbereichs überdeckt, so dass sich jeweils eine Kante der zweiten Anschlusskontaktschicht 42 innerhalb der Oberseite eines p⁺-Teilbereichs befindet.

In der Abbildung der Figur 8 ist eine zu der Darstellung der Figur 7 alternative Ausführungsform einer nicht erfindungsgemäßen Schottky-Diode gezeigt, wobei der p⁺-Bereich aus sechs zueinander beabstandeten Teilbereichen besteht und die zweite Kontaktschicht 42 eine Oberseite des ersten Teilbereichs sowie eine Oberseite des sechsten Teilbereichs teilweise überdeckt und die Oberseiten der dazwischenliegenden Teilbereiche jeweils vollständig überdeckt.

In den Abbildungen der Figuren 9 und 10 ist eine Ausführungsform eines erfindungsgemäßen III-V-Halbleiterbauelements 10 in einer seitlichen Ansicht und einer Aufsicht dargestellt. Im Folgenden werden nur die Unterschiede zu den vorangegangenen Abbildungen erläutert.

Das III-V-Halbleiterbauelement 10 ist als stapelförmiger IGBT-Halbleiterstruktur mit einem sogenannten non-punch-through Design ausgebildet, wobei der p⁺-Bereich als Substrat ausgebildet ist, gefolgt von einer schwach n- oder p-dotierten Zwischenschicht 24 und einer n⁻-Schicht 14, wobei sich der p-Bereich 28 von der Oberseite des Stapels bis zu einer Tiefe D7 in die n⁻-Schicht 14 hinein erstreckt. Ein weiterer Teil der Oberseite des Stapels wird von dem n⁺-Bereich 16 gebildet, wobei sich der n⁺-Bereich von der Oberseite des Stapels bis zu einer Tiefe D8 in den p-Bereich 28 hinein erstreckt und die Tiefe D7 des p-Bereichs 28 größer als die Tiefe D8 des n⁺-Bereichs 16 ist.

So bilden sich zwei an die Oberseite des Stapels der Halbleiterstruktur angrenzend pn-Übergänge aus, nämlich ein erster pn-Übergang 32 zwischen dem p-Bereich 28 und der n⁻-Schicht 14 und ein zweiter pn-Übergang 34 zwischen dem n⁺-Bereich 16 und dem p-Bereich 28. Eine dielektrische Schicht 30 mit einer Schichtdicke D9 überdeckt zumindest den ersten pn-Übergang 32 und den zweiten pn-Übergang 34 und ist mit der Oberseite des Stapels der Halbleiterstruktur, insbesondere mit dem n⁺-Bereich 16, dem p-Bereich 28 und der n⁻-Schicht 14 stoffschlüssig verbunden.

Die erste Anschlusskontaktschicht 40 ist als eine Metallschicht ausgebildet, wobei die Metallschicht stoffschlüssig und elektrisch leitfähig mit einer Unterseite des Stapels, also mit der Unterseite des p⁺-Bereichs verbunden ist. Der zweite Anschlusskontakt 42 ist als Feldplatte auf einer von der Halbleiterstruktur abgewandten Oberfläche der dielektrischen Schicht 30 ausgebildet. Ein dritter Anschlusskontakt 44 ist ebenfalls als Metallschicht ausgebildet, wobei die Metallschicht stoffschlüssig und elektrisch leitfähig mit einem von dem p-Bereich 28 und von dem n⁺-Bereich 16 gebildeten Teil der Oberseite des Stapels verbunden ist.

Die in der Abbildung der Figur 10 dargestellte Oberseite der Halbleiterstruktur ohne Kontaktschichten weist eine rechteckige Kontur auf, wobei der p-Bereich 28 sowie der n⁺-Bereich 16 kreisförmig ausgebildet sind.

In der Abbildung der Figur 11 ist eine weitere alternative Ausführungsform einer erfindungsgemäßen IGBT-Halbleiterstruktur dargestellt. Im Folgenden werden nur die Unterschiede zu der Abbildungen der Figur 9 erläutert. Die Halbleiterstruktur 10 ist als sogenannter Trench-IGBT ausgebildet.

Der p-Bereich 28 und der n⁺-Bereich 16 sind jeweils als Schichten auf der n⁻-Schicht 14 bzw. dem p-Bereich 28 ausgebildet, wobei die Halbleiterstruktur einen von der Oberseite durch den schichtförmigen n⁺-Bereich 16 und den schichtförmigen p-Bereich 28 bis in die n⁻-Schicht 14 hinein reichenden Graben 46, den sogenannten Trench, aufweist.

Der erste pn-Übergang 32 und der zweite pn-Übergang 34 verlaufen senkrecht zu einer Seitenfläche 48 des Grabens 46. Die Seitenfläche 48 sowie ein Boden 50 des Grabens 46 sind mit der dielektrischen Schicht 30 bedeckt. Der als Feldplatte ausgebildete zweite Anschlusskontakt 42 erstreckt sich entsprechend auf der dielektrischen Schicht 30. Die dritte Anschlusskontaktschicht 44 ist an einer der Seitenfläche 48 des Grabens 46 gegenüberliegenden Seitenfläche 52 der Halbleiterstruktur angeordnet und mit dem schichtförmigen n⁺-Bereich 16 sowie mit dem schichtförmigen p-Bereich 28 elektrisch leitfähig verbunden. Vorzugsweise verlaufen die Seitenflächen entlang kristallographischen Richtungen des III-V Halbleitermaterials.

## Patentansprüche

1. Stapelförmiges als IGBT-Struktur ausgebildetes monolithisches III-V-Halbleiterbauelement (10), aufweisend
einen aus III-V Halbleiterschichten gebildeten Stapel, mit einer Oberseite und einer Unterseite,
- ein als Substrat ausgebildeter schichtförmiger
p⁺-Bereich (12) mit einer Oberseite, einer Unterseite und einer elektrisch wirksamen Dotierstoffkonzentration von 5•10¹⁸-5•10²⁰ N/cm³, wobei
die Unterseite des p⁺ -Substrats die Unterseite des Stapels bildet, gefolgt von einer schwach n- oder p-dotierten Zwischenschicht (24) und einer n⁻-Schicht (14),
wobei die Zwischenschicht eine Schichtdicke zwischen 1 µm und 50 µm und eine Dotierstoffkonzentration von 10¹² N/cm³ - 10¹² N/cm³ aufweist und zumindest mit dem p⁺ Bereich stoffschlüssig verbunden ist,
und wobei die n⁻-Schicht (14) eine Unterseite und eine Oberseite, eine Dotierstoffkonzentration von 10¹²-10¹⁷ N/cm³ und eine Schichtdicke (D2) von 10 - 300 µm aufweist,
- mindestens einen p-Bereich (28),
- einen n⁺-Bereich (16) mit einer Oberseite, einer Unterseite und einer Dotierstoffkonzentration von mindestens 10¹⁹ N/cm³ ,
- eine dielektrische Schicht (30) und mindestens drei Anschlusskontaktschichten (40, 42, 44), wobei
der p-Bereich (28) eine Dotierstoffkonzentration von 10¹⁴ N/cm³ -10¹⁸ N/cm³ aufweist und an die n⁻-Schicht (14) und an den n⁺-Bereich (16) angrenzt, wobei
der mindestens eine p-Bereich (28) mit der n⁻-Schicht (14) einen ersten pn-Übergang (32) ausbildet, und
der n⁺-Bereich (16) mit dem mindestens einen p-Bereich (28) einen zweiten pn-Übergang (34) ausbildet, und
die dielektrische Schicht (30) zumindest den ersten p/n-Übergang (32) und den zweiten pn-Übergang (34) überdeckt und mit der n⁻-Schicht (14), dem p-Bereich (28) und dem n⁺-Bereich (16) stoffschlüssig verbunden ist, und
die erste Anschlusskontaktschicht (40) elektrisch leitfähig mit der Unterseite des schichtförmigen p⁺-Bereichs (12) verbunden ist, und
die zweite Anschlusskontaktschicht (42) als Feldplatte auf der dielektrischen Schicht (30) ausgebildet ist und als Gate der IGBT-Struktur dient, und
die dritte Anschlusskontaktschicht (44) mit dem mindestens einen p-Bereich (28) und dem mindestens einen n⁺-Bereich (16) elektrisch leitfähig verbunden ist, und
die Schichten und die Bereiche jeweils eine GaAs-Verbindung umfassen oder aus einer GaAs-Verbindung bestehen, und
die n⁻-Schicht (14) Defekte mit einer Konzentration von mindestens 10¹⁴ N/cm³ umfasst, und
die Dotierstoffkonzentration in eine Richtung von der Unterseite der n⁻-Schicht 14 zu der Oberseite der n⁻-Schicht 14 um einen Faktor von 1,5 bis 2,5 zunimmt.

2. Stapelförmiges als IGBT-Struktur ausgebildetes monolithisches III-V-Halbleiterbauelement (10) nach Anspruch 1, **dadurch gekennzeichnet, dass** der auf der n⁻-Schicht (14) ausgebildete p-Bereich (28) und der auf dem p-Bereich ausgebildete n⁺-Bereich (16) jeweils als Schichten ausgebildet sind, und
der aus den III-V Halbleiterschichten gebildete Stapel einen von der Oberseite durch den schichtförmigen n⁺-Bereich (16) und den schichtförmigen p-Bereich (28) bis in die n⁻-Schicht (14) hineinreichenden Graben (46) aufweist.

3. Stapelförmiges als IGBT-Struktur ausgebildetes monolithisches III-V-Halbleiterbauelement (10) nach Anspruch 2, **dadurch gekennzeichnet, dass** die Seitenfläche (48) sowie ein Boden (50) des Grabens (46) mit der dielektrischen Schicht (30) bedeckt sind, und der als Feldplatte ausgebildete zweite Anschlusskontakt (42) sich auf der dielektrischen Schicht (30) erstreckt, und die dritte Anschlusskontaktschicht (44) an einer der Seitenfläche (48) des Grabens (46) gegenüberliegenden Seitenfläche (52) der Halbleiterstruktur angeordnet ist, wobei der erste pn-Übergang 32 und der zweite pn-Übergang 34 senkrecht zu einer Seitenfläche 48 des Grabens 46 verlaufen.

4. Stapelförmiges III-V-Halbleiterbauelement (10) nach einem der Ansprüche 1 - 3, **dadurch gekennzeichnet, dass** der p⁺-Bereich (12) eine Schichtdicke (D1) von 50 - 500 µm aufweist.

5. Stapelförmiges III-V-Halbleiterbauelement (10) nach Anspruch 2, **dadurch gekennzeichnet, dass** der schichtförmige n⁺-Bereich (16) eine Schichtdicke (D3) kleiner als 30 µm aufweist.

6. Stapelförmiges III-V-Halbleiterbauelement (10) nach einem der Ansprüche 1 bis 5, **dadurch gekennzeichnet, dass** der p⁺-Bereich (12) Zink umfasst.

7. Stapelförmiges III-V-Halbleiterbauelement (10) nach einem der Ansprüche 1 bis 6, **dadurch gekennzeichnet, dass** der n⁺-Bereich (16) Chrom und/oder Silizium und/oder Palladium und/oder Zinn umfasst.

8. Stapelförmiges III-V-Halbleiterbauelement (10) nach einem der Ansprüche 1 bis 7, **dadurch gekennzeichnet, dass** die n⁻-Schicht (14) Silizium und/oder Palladium und/oder Zinn umfasst.

9. Stapelförmiges III-V-Halbleiterbauelement (10) nach einem der Ansprüche 1 bis 8, **dadurch gekennzeichnet, dass** die n⁻-Schicht (14) Chrom mit einer Konzentration in einem Bereich zwischen 1•10¹³ N/cm³ und 5•10¹⁶ N/cm³ umfasst.

10. Stapelförmiges III-V-Halbleiterbauelement (10) nach einem der Ansprüche 1 bis 9, **dadurch gekennzeichnet, dass** die n⁻-Schicht (14) Defekte mit einer Konzentration von mindestens 10¹³ N/cm³ umfasst.

## Claims

1. Stacked monolithic III-V semiconductor module (10) constructed as an IGBT structure comprising
a stack, which is formed from III-V semiconductor layers, with an upper side and a lower side,
- a layer-shaped p⁺ region (12), which is constructed as a substrate, with an upper side, a lower side and an electrically effective dopant concentration of 5•10¹⁸ - 5•10²⁰ N/cm³, wherein
the lower side of the p⁺ substrate forms the lower side of the stack, followed by a weakly n-doped or p-doped intermediate layer (24) and a n⁻ layer (14),
wherein the intermediate layer has a layer thickness between 1 µm and 50 µm and a dopant concentration of 10¹² N/cm³ - 10¹⁷ N/cm³ and is connected by material couple at least with the p⁺ region,
and wherein the n⁻ layer (14) has a lower side, an upper side, a dopant concentration of 10¹² - 10¹⁷ N/cm³ and a layer thickness (D2) of 10 - 300 µm,
- at least one p region (28),
- an n⁺ region (16) with an upper side, a lower side and a dopant concentration of at least 10¹⁹ N/cm³,
- a dielectric layer (30) and at least three terminal contact layers (40, 42, 44),
wherein
the p region (28) has a dopant concentration of 10¹⁴ N/cm³ - 10¹⁸ N/cm³ and adjoins the n⁻layer (14) and the n⁺ region (16), wherein
the at least one p region (28) forms together with the the n⁻ layer (14) a first pn transition (34), and
the n⁺ region (16) forms together with the at least one p region (28) a second pn transition (34), and
the dielectric layer (30) covers at least the first pn transition (32) and the second pn transition (34) and is connected by material couple with the n⁻ layer (14), the p region (28) and the n⁺ region (16), and
the first terminal contact layer (40) is electrically conductively connected with the lower side of the layer-shaped p⁺ region (12), and
the second terminal contact layer (42) is formed as a field plate on the dielectric layer (30) and serves as gate of the IGBT structure, and
the third terminal contact layer (44) is electrically conductively connected with the at least one p region (28) and the at least one n⁺ region (16), and
the layers and the regions each comprise a GaAs compound or consist of a GaAs compound, and
the n⁻ layer (14) comprises defects with a concentration of at least 10¹⁴ N/cm³, and
the dopant concentration increases in a direction from the lower side of the n⁻ layer (14) to the upper side of the n⁻ layer (14) by a factor of 1.5 to 2.5.

2. Stacked monolithic III-V semiconductor module (10), which is constructed as an IGBT structure, according to claim 1, **characterised in that** the p region (28) formed on the n⁻ layer (14) and the n⁺ region (16) formed on the p region are each formed as layers and the stack formed from the III-V semiconductor layers has a trench (46) extending from the upper side through the layer-shaped n⁺ region (16) and the layer-shaped p region (28) into the n⁻ layer (14).

3. Stacked monolithic III-V semiconductor module (10), which is constructed as an IGBT structure, according to claim 2, **characterised in that** the side surface (48) as well as a base (50) of the trench (46) are covered by the dielectric layer (30), the second terminal contact (42) formed as a field plate extends on the dielectric layer (30) and the third terminal contact layer (44) is arranged at a side surface (52), which is opposite the side surface (48) of the trench (46), of the semiconductor structure,
wherein the first pn transition (32) and the second pn transition (34) extend perpendicularly to a side surface (48) of the trench (46).

4. Stacked III-V semiconductor module (10) according to any one of claims 1 to 3, **characterised in that** the p⁺ region (12) has a layer thickness (D1) of 50 - 500 µm.

5. Stacked III-V semiconductor module (10) according to claim 2, **characterised in that** the layer-shaped n⁺ region (16) has a layer thickness (D3) smaller than 30 µm.

6. Stacked III-V semiconductor module (10) according to any one of claims 1 to 5, **characterised in that** the p⁺ region (12) comprises zinc.

7. Stacked III-V semiconductor module (10) according to any one of claims 1 to 6, **characterised in that** the n⁺ region (16) comprises chromium and/or silicon and/or palladium and/or tin.

8. Stacked III-V semiconductor module (10) according to any one of claims 1 to 7, **characterised in that** the n⁻ layer (14) comprises silicon and/or palladium and/or tin.

9. Stacked III-V semiconductor module (10) according to any one of claims 1 to 8, **characterised in that** the n⁻ layer (14) comprises chromium with a concentration in a range between 1•10¹³ N/cm³ and 5•10¹⁶ N/cm³.

10. Stacked III-V semiconductor module (10) according to any one of claims 1 to 9, **characterised in that** the n⁻ layer (14) comprises defects with a concentration of at least 10¹⁵ N/cm³.

## Revendications

1. Dispositif semi-conducteur III-V monolithique (10) en forme d'empilement, conçu comme une structure IGBT, comportant un empilement formé de couches semi-conductrices III-V, avec une face supérieure et une face inférieure,
- une zone p+ en forme de couche (12) conçue comme un substrat, avec une face supérieure, une face inférieure et une concentration en dopant électriquement efficace de 5•10¹⁸ - 5•10²⁰ N/cm³, la face inférieure du substrat p⁺ formant la face inférieure de l'empilement, suivie d'une couche intermédiaire (24) faiblement dopée n ou p et d'une couche n⁻ (14), la couche intermédiaire ayant une épaisseur comprise entre 1 µm et 50 µm et une concentration en dopant de 10¹² N/cm³ - 10¹⁷ N/cm³ et étant reliée par adhérence à au moins la zone p⁺, et la couche n⁻ (14) présentant une face inférieure et une face supérieure, une concentration en dopant de 10¹² - 10¹⁷ N/cm³ et une épaisseur de couche (D2) de 10 - 300 µm,
- au moins une zone p (28),
- une zone n⁺ (16) avec une face supérieure, une face inférieure et une concentration en dopant d'au moins 10¹⁹ N/cm³,
- une couche diélectrique (30) et au moins trois couches de contact de raccordement (40, 42, 44),
la zone p (28) présentant une concentration en dopant de 10¹⁴ N/cm³ - 10¹⁸ N/cm³ et étant adjacente à la couche n⁻ (14) et à la zone n⁺ (16), la au moins une zone p (28) formant avec la couche n⁻ (14) une première jonction pn (32), et la zone n⁺ (16) formant une deuxième jonction pn (34) avec la au moins une zone p (28), et la couche diélectrique (30) recouvrant au moins la première jonction p/n (32) et la deuxième jonction pn (34) et étant reliée par adhérence de matière à la couche n⁻(14), la zone p (28) et la zone n⁺ (16), et la première couche de contact de raccordement (40) étant reliée de manière électriquement conductrice à la face inférieure de la zone p⁺ en forme de couche (12), et la deuxième couche de contact de raccordement (42) étant formée comme plaque de champ sur la couche diélectrique (30) et servant de grille à la structure IGBT, et la troisième couche de contact de raccordement (44) étant reliée de manière électriquement conductrice à la au moins une zone p (28) et à la au moins une zone n⁺ (16), et les couches et les zones comprennent chacune un composé de GaAs ou étant constituées d'un composé de GaAs, et la couche n⁷ (14) comprenant des défauts avec une concentration d'au moins 10¹⁴ N/cm³, et la concentration en dopant augmentant d'un facteur de 1,5 à 2,5 dans une direction allant de la face inférieure de la couche n⁻ 14 vers la face supérieure de la couche n⁻ 14.

2. Dispositif semi-conducteur III-V monolithique (10) en forme d'empilement conçu comme une structure IGBT selon la revendication 1, **caractérisé en ce que** la zone p (28) formée sur la couche n⁻ (14) et la zone n⁺ (16) formée sur la zone p sont chacune conçues comme des couches, et l'empilement formé à partir des couches semi-conductrices III-V présente une tranchée (46) s'étendant depuis la face supérieure à travers la zone n⁺ en forme de couche (16) et la zone p en forme de couche (28) jusqu'à la couche n⁻ (14).

3. Dispositif semi-conducteur III-V monolithique (10) en forme d'empilement, formé comme une structure IGBT, selon la revendication 2, **caractérisé en ce que** la surface latérale (48) et un fond (50) de la tranchée (46) sont recouverts de la couche diélectrique (30), et le deuxième contact de raccordement (42) formé en tant que plaque de champ s'étend sur la couche diélectrique (30), et la troisième couche de contact de connexion (44) est disposée sur une surface latérale (52) de la structure semi-conductrice opposée à la surface latérale (48) de la tranchée (46), la première jonction pn 32 et la deuxième jonction pn 34 s'étendant perpendiculairement à une surface latérale 48 de la tranchée 46.

4. Dispositif semi-conducteur III-V en forme d'empilement (10) selon l'une des revendications 1 à 3, **caractérisé en ce que** la zone p⁺ (12) présente une épaisseur de couche (D1) de 50 à 500 µm.

5. Dispositif semi-conducteur III-V en forme d'empilement (10) selon la revendication 2, **caractérisé en ce que** la zone n⁺ en forme de couche (16) présente une épaisseur de couche (D3) inférieure à 30 µm.

6. Dispositif semi-conducteur III-V en forme d'empilement (10) selon l'une des revendications 1 à 5, **caractérisé en ce que** la zone p⁺ (12) comprend du zinc.

7. Dispositif semi-conducteur III-V en forme d'empilement (10) selon l'une des revendications 1 à 6, **caractérisé en ce que** la zone n⁺ (16) comprend du chrome et/ou du silicium et/ou du palladium et/ou de l'étain.

8. Dispositif semi-conducteur III-V en forme d'empilement (10) selon l'une des revendications 1 à 7, **caractérisé en ce que** la couche n⁻ (14) comprend du silicium et/ou du palladium et/ou de l'étain.

9. Dispositif semi-conducteur III-V en forme d'empilement (10) selon l'une des revendications 1 à 8, **caractérisé en ce que** la couche n⁻ (14) comprend du chrome avec une concentration comprise entre 1•10¹³ N/cm³ et 5•10¹⁶ N/cm³.

10. Dispositif semi-conducteur III-V en forme d'empilement (10) selon l'une des revendications 1 à 9, **caractérisé en ce que** la couche n⁻ (14) comprend des défauts avec une concentration d'au moins 10¹⁵ N/cm³.
